# EUROPÄISCHE PATENTSCHRIFT

(11) **EP 3 461 005 B1**
(45) Veröffentlichungstag und Bekanntmachung des Hinweises auf die Patenterteilung: **29.11.2023**
(21) Anmeldenummer: 17193236.1
(22) Anmeldetag: 26.09.2017
(51) Int. Cl.: H03K 3/03

(54) **VERFAHREN UND SYSTEM ZUR FREQUENZKORREKTUR EINES RINGOSZILLATORS**
METHOD AND SYSTEM FOR FREQUENCY CORRECTION FOR A RING OSCILLATOR
PROCÉDÉ ET SYSTÈME DE CORRECTION DE FRÉQUENCE D'UN OSCILLATEUR EN ANNEAU

(43) Veröffentlichungstag der Anmeldung: 27.03.2019
(73) Patentinhaber: Siemens Aktiengesellschaft, 80333 München (DE)
(72) Erfinder: Muhr, Hannes, 2463 Gallbrunn (AT); Taucher, Herbert, 1190 Wien (AT); Tomic, Dusan, 1220 Wien (AT)
(74) Vertreter: Siemens Patent Attorneys

(56) Entgegenhaltungen:
- EP-A1- 1 536 561
- US-A1- 2005 057 315
- US-A1- 2016 226 501

## Beschreibung

### Technisches Gebiet

Die vorliegende Erfindung betrifft ein Verfahren zur Frequenzkorrektur für einen Ringoszillator, welcher in einem programmierbaren Logikbaustein, insbesondere in einem so genannten Field Programmable Gate Array oder FPGA, eingesetzt wird, um ein periodisches Signal zu erzeugen. Der Ringoszillator besteht aus einer ungeraden Anzahl an gegengekoppelten, in Serie angeordneten Verzögerungselementen. Weiterhin betrifft die vorliegende Erfindung auch ein System zur Durchführung des erfindungsgemäßen Verfahrens.

### Stand der Technik

Heutzutage werde in vielen elektronischen Geräten, elektronischen Schaltungen und Einheiten Logikbausteine eingesetzt. Im Bereich der Elektronik wird eine digitale, integrierte Schaltung als Logikbaustein bezeichnet. Logikbausteine können in einer Bandbreite von sehr einfachen bis hin zu sehr komplexen logischen Schaltfunktionen realisiert werden. Die Palette an Logikbausteinen reicht beispielsweise von Bauelementen mit mehreren einfachen Logikgattern (wie z.B. UND-, ODER- und NAND-Gattern) sowie bistabilen Kippglieder bzw. so genannten Flipflops bis hin zu programmierbaren Logikbausteinen wie z.B. anwendungsspezifisch programmierbare integrierte Schaltungen bzw. Application-specific integrated Circuits (ASICs) und so genannten Field Programmable Gate Arrays bzw. FPGAs.

Bei ASICs werden die jeweiligen Funktionen und Anwendungen bereits bei Design, Entwicklung und Herstellung der integrierten Schaltung eindeutig festgelegt. D.h. sie sind fest vorgegeben und sollten nach einer Herstellung nicht mehr manipulierbar sein. Mittlerweile gibt es aber auch viele ASICs, in welche Mikroprozessoren, Signalprozessoren, etc. integriert sind, und welche damit für die darauf ablaufenden Funktionen und Anwendungen eine gewisse Flexibilität bieten.

Im Gegensatz zu den nur sehr begrenzt veränderbaren ASICs können FPGAs durch Definitionen von Funktionsstrukturen und durch Vorgabe von Strukturvorschriften programmiert werden. Das bedeutet, die Schaltungsstrukturen eines FPGAs können nach der Herstellung durch in den FPGA geladene Daten (z.B. Strukturvorschriften, Schaltpläne, etc.) festgelegt und/oder verändert werden. FPGAs sind daher flexibel einsetzbar und mittels Programmierung können unterschiedliche Schaltungen und Funktionen realisiert bzw. implementiert werden. Mit Hilfe von FPGAs können daher von einfachen Zählern (z.B. Synchronzähler, etc.) bis zu hochkomplexen Schaltungen (z.B. Mikroprozessoren, etc.) entwickelt werden.

Es kann für die in einem programmierbaren Logikbaustein (z.B. ASIC, FPGA) realisierten Anwendungen erforderlich sein, beispielsweise für Synchronisierung und/oder Steuerung von internen Prozessen, Funktionen, etc. ein periodisches Signal z.B. als Takt zu erzeugen. Dabei kann es notwendig sein, dass dieses periodische Signal ohne externe Taktquelle (z.B. externer Oszillator, Oszillatorquarz, etc.) generiert wird, beispielsweise wenn:
- sequentielle Abläufe von einer externen Taktquelle unabhängig ablaufen sollen;
- Bauteilkosten für eine externen Taktquelle eingespart werden soll
- und/oder eine Verlustleistung des Logikbausteins optimiert werden soll.

Für derartige Anwendungsfälle können Ringoszillatoren eingesetzt werden, mit welchen in einem programmierbaren Logikbaustein wie z.B. FPGAs oder ASICs periodische Signale ohne externe Taktquelle erzeugt werden können.

Ein Ringoszillator ist eine elektronische Schwingschaltung, welche selbständig ohne Hilfe von externen Komponenten wie z.B. Kondensatoren oder Spulen anschwingt. Ein Ringoszillator ist üblicherweise aus einer ungeraden Anzahl an Verzögerungselementen aufgebaut, welche in Serie angeordnet sind. Vom Ausgang des letzten Verzögerungselements der Serienschaltung der ungeraden Anzahl an Verzögerungselementen erfolgt eine Rückkopplung an den Eingang des ersten Verzögerungselements dieser Serienschaltung. Als Verzögerungselemente können beispielsweise Transitoren in Emitterschaltung oder Inverter bzw. invertierende digitale Logiken - so genannte NOT-Gatter - eingesetzt werden.

Das von einem Ringoszillator erzeugte, periodische Signal ist üblicherweise ein Rechtecksignal, wobei eine Frequenz dieses Signals vor allem durch die Anzahl der Verzögerungselemente sowie deren jeweilige Verzögerungszeit bestimmt wird. Die Verzögerungszeit des jeweiligen Verzögerungselements ist durch vorhandene Lastkapazitäten bedingt. Diese Verzögerungszeit stellt eine Eigenverzögerung des jeweiligen Verzögerungselements dar und unterliegt verhältnismäßig starken Streuungen, welche durch einen Produktionsprozess des jeweiligen Verzögerungselements bedingt sind und zudem von der jeweiligen Versorgungsspannung und Umgebungstemperatur abhängen. Das bedeutet, dass die Frequenz eines Ringoszillators ebenfalls stark von der jeweiligen Versorgungsspannung und Temperatur abhängig ist. Ein Wert der Frequenz des mit einem Ringoszillator erzeugten, periodischen Signals ist daher nur ungenau vorhersagbar. Ringoszillatoren können damit für Anwendungen mit frequenzgenauen und frequenzstabilen Anforderungen nur begrenzt eingesetzt werden.

Daher werden Ringoszillatoren typischerweise in Anwendungen eingesetzt, bei welchen es nicht auf ein genaues und stabiles Zeitverhalten bzw. periodisches Signal ankommt. Ringoszillatoren werden daher z.B. für Schaltzeitmessungen oder als Sensoren eingesetzt, mit welchen ein analoges Signal (z.B. Druck, Feuchtigkeit oder Temperatur) in eine dazu fast proportionale Frequenz umgesetzt wird. Eine weitere Anwendung finden Ringoszillatoren z.B. bei der Realisierung von Zufallsgeneratoren mittels programmierbaren Logikbausteinen wie z.B. FPGAs. Für Anwendungen und Funktionen in programmierbaren Logikbausteinen, welche ein frequenzgenaues und/oder frequenzstabiles, periodisches Signal erfordern, werden beispielsweise externe Taktquellen wie z.B. Oszillatoren mit Schwingquarzen, etc. verwendet. Ein Einsatz von externen Taktquellen bzw. Oszillatoren weist allerdings den Nachteil auf, dass ein Leistungs- bzw. Energiebedarf des Logikbausteines erhöht ist und dass neben zusätzliche Anschlüsse für den externen Bauteile bzw. die externe Taktquelle notwendig sind, welche neben einen erhöhten Platzbedarf auch mit entsprechenden Bauteilkosten verbunden sind.

Eine Frequenzkorrektur bei Ringoszillatoren kann beispielsweise durch ein serielles Zuschalten einer Verzögerungsschaltung oder einer geraden Anzahl von Invertern und/oder Pufferelementen erfolgen. D.h. es werden z.B. zusätzlich Verzögerungselement bzw. Inverter und/oder Puffer in Serie zur den Verzögerungselementen des Ringoszillators (z.B. am Ausgangs des letzten Verzögerungselements) z.B. durch entsprechende Ansteuerung von Schaltelementen in den Ringoszillator eingefügt. Eine derartige Frequenzkorrektur ist beispielsweise in der Schrift JP 20040056561 A beschrieben. Allerdings sind bei einer derartigen Frequenzkorrektur der Frequenzauflösung Grenzen gesetzt. Weiterhin ist beim seriellen Zuschalten von Verzögerungselementen bzw. Invertern und/oder Pufferelementen sicherzustellen, dass eine Zuschaltung beispielsweise nur dann erfolgt, wenn ein Signalwechsel gerade außerhalb des zugeschalteten Teils durchgeführt wird. Beim Zuschalten während eines Signalwechsels kann es beispielsweise zu einem meta-stabilen Zustand kommen. Dadurch können sich im schlimmsten Fall mehrere Signalwellen in der Ringoszillatorschaltung ausbreiten, welche beispielsweise zu weitreichenden Funktionsstörungen im jeweiligen Logikbaustein führen können.

Es wird auch das Dokument US 2016226501 A1 erwähnt, in dem Folgendes beschrieben wird: ein Ringoszillator mit einer Reihe von Stufen. Jede Stufe umfasst einen Satz von Lastauswahltransistoren, die jeweils mit einem Lastkondensator gekoppelt sind. Eine Treibervorrichtung steuert die Lastauswahltransistoren entsprechend einer Lastkonfiguration.

Es wird auch das Dokument US 2005057315 A1 erwähnt, in dem Folgendes beschrieben wird:eine Verzögerungsstufenschaltung für Ringoszillator mit wählbarer Widerstandslast, die ihrerseits mit einer Versorgung gekoppelt ist. Die Last besteht aus einer Reihe von Widerständen, die, wenn sie in Reihe mit einer Gate-Source-Kapazität gekoppelt sind, die von den MOSFET-Bauelementen bereitgestellt wird, eine gewünschte R-C-Zeitkonstante erzeugen, um die Verzögerung eines Differenztransistorpaars zu definieren.

### Darstellung der Erfindung

Der Erfindung liegt daher die Aufgabe zugrunde, ein Verfahren sowie ein System zur Durchführung des Verfahrens anzugeben, mit welchen mit geringen Aufwand und ohne zusätzliche, externe Bauteile eine Frequenzkorrektur eines Ringoszillators in einem programmierbaren Logikbaustein dynamisch und störungsfrei durchgeführt werden kann.

Diese Aufgabe wird durch ein Verfahren sowie ein System der eingangs genannten Art mit den Merkmalen gemäß den unabhängigen Patentansprüchen gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren zur Frequenzkorrektur für einen Ringoszillator, von welchem ein periodisches Signal in einem programmierbaren Logikbaustein erzeugt wird und welcher aus einer ungeraden Anzahl an gegengekoppelten, in Serie angeordneten Verzögerungselementen besteht, dadurch gekennzeichnet, dass zumindest einem Verzögerungselement des Ringoszillators zumindest ein Lastelement einer zusätzlichen Last zugeordnet wird, dass eine aktuelle Frequenz des vom Ringoszillator erzeugten, periodischen Signals von einer Steuereinheitmit einer vorgegebenen Frequenz verglichen wird, dass bei Abweichung zwischen der aktuellen Frequenz des vom Ringoszillator erzeugten, periodischen Signals und der vorgegebenen Frequenz von der Steuereinheit ein Steuersignal erzeugt wird, dass aus dem Steuersignal der Steuereinheit von einer Konfigurationseinheit Schaltdaten zum Einstellen einer Schalteinheit generiert werden, dass die Schalteinheit mittels der Schaltdaten derart programmiert wird, dass das zumindest eine Lastelement einem Ausgang jenes Verzögerungselements zugeschaltet wird, welchem das zumindest eine Lastelement zugeordnet ist, und dass die Schalteinheit in einem so genannten partiell re-konfigurierbaren Bereich des programmierbaren Logikbausteins angeordnet wird.

Der Hauptaspekt der gegenständlichen Erfindung besteht darin, dass auf sehr einfache Weise und mit geringem Aufwand - jeweils in Abhängigkeit von einer Dimensionierung des Lastelements bzw. einer Anzahl der zuschaltbaren Lastelemente eine feinstufige Korrektur der Frequenz des vom Ringoszillator erzeugten Signals durchgeführt wird. Das zumindest eine Lastelement oder mehrere Lastelemente bilden die zuschaltbare Last, deren Aufbau und Dimensionierung im jeweiligen Anwendungsfall an die entsprechenden Anforderungen - vor allem an die Frequenz des Ringoszillators - angepasst werden muss. Das Zuschalten einer zusätzlichen Last an einem Ausgang von zumindest einem Verzögerungselement des Ringoszillators bedeutet, dass eine Eigenfrequenz ja nach Größe und Dimensionierung der Last geringfügig reduziert wird, und ermöglicht auf einfache Weise und mit relativ geringem Aufwand eine Korrektur der Frequenz des Ringoszillators auf Basis einer vorgegebenen Frequenz.

Weiterhin werden eine Frequenzgenauigkeit und/oder eine Frequenzstabilität des Ringoszillators ohne zusätzliche Kosten oder zusätzliche Bauteile erhöht. Das ausgangsseitige Zuschalten einer Last, welche aus zumindest einem Lastelement besteht, welches zumindest einem Verzögerungselement des Ringoszillators zugeordnet ist, ermöglicht außerdem eine Verwendung von Ringoszillatoren zur Synchronisation des programmierbaren Logikbausteins, ohne dass eine aufwendige und teure Lösung mit einer so genannten Phasenregelschleife oder Phase Locked Loop (PLL) eingesetzt werden muss.

Es ist weiterhin von Vorteil, wenn bei einer Abweichung der aktuellen Frequenz des vom Ringoszillator erzeugten, periodischen Signals von der vorgegebenen Frequenz von einer Konfigurationseinheit Schaltdaten zum Einstellen der Schalteinheit aus einem Steuersignal der Steuereinheit generiert werden. Über die anhand des Steuersignals erzeugten Schaltdaten kann dann die Schalteinheit in einfacher und rascher Weise entsprechend eingestellt werden, damit das zumindest eine Lastelement ausgangsseitig dem zugeordneten Verzögerungselement zugeschaltet wird.

Dabei ist es auch günstig, wenn das zumindest eine Lastelement aus einer Verbindung mit angeschlossenem Logikelement aufgebaut wird, und wenn das zumindest eine Lastelement durch die Verbindung bei entsprechender Einstellung der Schalteinheit dem Ausgang jenes Verzögerungselements zugeschaltet wird, welchem das zumindest einen Lastelement zugeordnet ist. Das bedeutet, die Verbindung des zumindest einen Lastelements wird beispielsweise mittels entsprechender Schaltdaten der Konfigurationseinheit von der Schalteinheit mit dem Ausgang des jeweils zugeordneten Verzögerungselements des Ringoszillators verbunden. Die Schalteinheit besteht dazu idealerweise aus Schaltelementen bzw. Schaltungsknoten, durch welche die Verbindung des zumindest eine Lastelements entsprechend geschlossen werden kann bzw. an den Ausgangs des zugehörigen Verzögerungselements des Ringoszillators angebunden werden kann.

ErfindungsgemaB wird dazu die Schalteinheit in einem so genannten partiell re-konfigurierbaren Bereich (oder Partial Reconfiguration Area) des programmierbaren Logikbausteins angeordnet. Dadurch kann die Schalteinheit dynamisch bzw. während des Betriebs des restlichen Logikbauteins mit Hilfe der Schaltdaten der Konfigurationseinheit entsprechend eingestellt bzw. programmiert wird, um die Frequenz des periodischen Signals des Ringoszillators entsprechend der vorgegebenen Frequenz geregelt werden.

Zusätzlich zur Schalteinheit kann auch das zumindest eine Lastelement im so genannten partiell re-konfigurierbaren Bereich des programmierbaren Logikbausteins angeordnet werden. Dadurch kann in vorteilhafter Weise eine Dimensionierung des zumindest einen Lastelements als auch einen Anzahl der Lastelemente und/oder eine Zuordnung zu den Verzögerungselementen des Ringoszillators dynamisch an die jeweiligen Anforderungen - z.B. zur Optimierung der Regelung - angepasst werden.

Mit dem erfindungsgemäßen Verfahren kann die aktuelle Frequenz des vom Ringoszillator erzeugten, periodischen Signals in vorteilhafter Weise zu einem vorgegebenen Zeitpunkt entsprechend der vorgegebenen Frequenz kalibriert werden. Dabei wird mit Hilfe der Steuereinheit zu einem definierten Zeitpunkt - z.B. beim Starten einer auf dem jeweiligen Logikbaustein implementierten Anwendung oder Funktion - die aktuelle Frequenz mit der vorgegebenen Frequenz verglichen. Bei einer Abweichung wird die aktuelle Frequenz durch Zuschalten des zumindest einen Lastelements einmalig auf die vorgegebenen Frequenz eingestellt.

Alternativ kann die aktuelle Frequenz des vom Ringoszillator erzeugten, periodischen Signals aber auch laufend entsprechend der vorgegebenen Frequenz nachgeregelt wird. D.h. von der Steuereinheit wird laufend die aktuelle Frequenz des Ringoszillators mit der vorgegebenen Frequenz verglichen. Bei einer festgestellten Abweichung wird dann mit Hilfe der Konfigurationseinheit und der Schalteinheit das zumindest eine Lastelement bzw. bei mehreren Lastelementen die Lastelemente entsprechend zu- oder weggeschaltet, um die aktuelle Frequenz auf dem vorgegebenen Wert zu halten. Damit kann mit dem Ringoszillator sehr einfach eine gute Frequenzgenauigkeit und Frequenzstabilität erzielt werden.

Die Lösung der angegebenen Aufgabe erfolgt weiterhin durch ein System zur Durchführung eines Verfahrens zur Frequenzkorrektur für einen Ringoszillator welches einen Ringoszillator zum Erzeugen von periodischen Signalen in einem programmierbaren Logikbaustein umfasst, wobei der Ringoszillator aus einer ungeraden Anzahl an gegengekoppelten, in Serie angeordneten Verzögerungselementen besteht,dadurch gekennzeichnet, dass das System aufweist:- eine Steuereinheit zum Vergleichen einer aktuellen Frequenz des erzeugten, periodischen Signals des Ringoszillators mit einer vorgegebenen Frequenz und zum Erzeugen eines Steuersignals bei einer Abweichung der aktuellen Frequenz des erzeugten, periodischen Signals des Ringoszillators von der vorgegebenen Frequenz,- eine zusätzliche Last für eine Frequenzkorrektur des Ringoszillators mit zumindest einem Lastelement, wobei zumindest einem Verzögerungselement des Ringoszillators das zumindest eine Lastelement zugeordnet ist,- eine Schalteinheit, welche bei einer Abweichung der aktuellen Frequenz des erzeugten, periodischen Signals des Ringoszillators von der vorgegebenen Frequenz derart mittels Schaltdaten programmierbar ist, dass das zumindest eine Lastelement der zusätzlichen Last einem Ausgang jenes Verzögerungselements zugeschaltet wird, welchem das zumindest eine Lastelement zugeordnet ist, und wobei zumindest die Schalteinheit in einem so genannten partiell re-konfigurierbaren Bereich des Logikbausteins angeordnet ist, undeine Konfigurationseinheit, welche auf Basis eines Steuersignals der Steuereinheit die Schaltdaten zum Einstellen der Schalteinheit generiert.

Der Hauptaspekt des erfindungsgemäßen Systems besteht ebenfalls darin, mit geringem Aufwand eine feinstufige Korrektur der Frequenz des vom Ringoszillators erzeugten, periodischen Signals - je nach Anzahl und Dimensionierung der zuschaltbaren Lastelemente - durchführbar ist. Ein Zuschalten einer zusätzlichen Last an den Ausgang eines Verzögerungselements des Ringoszillators bedeutet eine zusätzliche Last für das periodische Signal und führt zu einer geringfügigen Reduktion der Eigenfrequenz, welche von der Größe und Dimensionierung der zusätzlichen Last abhängt. Damit ermöglicht das erfindungsgemäße System wie das erfindungsgemäße Verfahren auf einfache Weise eine Korrektur der Frequenz des Ringoszillators und/oder eine Steigerung einer Frequenzgenauigkeit und/oder einer Frequenzstabilität eines Ringoszillators ohne zusätzliche Kosten oder zusätzliche Bauteile. Weiterhin werden durch ein ausgangsseitiges Zuschalten des zumindest einen Lastelements beim zugeordneten Verzögerungselement des Ringoszillators Meta-stabilen Zustände und im schlimmsten Fall Ausfälle des Ringoszillators vermieden werden.

Weiterhin ermöglicht das erfindungsgemäße System einen Einsatz von Ringoszillatoren zur Taktung eines programmierbaren Logikbausteins, ohne eine aufwendige und teure Lösung wie z.B. eine externe Beschaltung mittels einer externen Taktquelle wie z.B. eines Quarzoszillators zu verwenden.

Weiterhin umfasst das erfindungsgemäße System idealerweise eine Konfigurationseinheit, welche auf Basis eines Steuersignals der Steuereinheit Schaltdaten zum Einstellen der Schalteinheit generiert. Mit Hilfe der Konfigurationseinheit können auf einfache und rasche Weise aus einem Steuersignal Schaltdaten abgeleitet werden und die Schalteinheit derart eingestellt bzw. programmiert werden, dass das zumindest eine Lastelement ausgangsseitig dem jeweils zugeordneten Verzögerungselement zugeschaltet wird und dadurch eine entsprechende Frequenzkorrektur erfolgt.

Eine zweckmäßige Weiterbildung der Erfindung sieht vor, dass das zumindest eine Lastelement aus einer Verbindung mit daran angeschlossenem Logikelement besteht, wobei das zumindest eine Lastelement bei entsprechender Einstellung der Schalteinheit über die Verbindung dem Ausgang des zugeordneten Verzögerungselements zuschaltbar ist. D.h. ein Zuschalten des zumindest einen Lastelements an den Ausgangs des jeweils zugeordneten Verzögerungselements erfolgt über die Verbindung, welche durch einen entsprechende Einstellung der Schalteinheit bzw. der Schaltelemente oder Schaltknoten der Schalteinheit mit dem Ausgang des jeweils zugeordneten Verzögerungselements verknüpft wird. Das an der Verbindung angeschlossene Logikelement bildet dann die jeweilige Last für die entsprechende Frequenzkorrektur.

Es ist von Vorteil, wenn zusätzlich zum zumindest eine Lastelement zumindest ein weiteres Lastelement vorgesehen ist, welches demselben Verzögerungselement wie das zumindest eine Lastelement oder einem weiteren Verzögerungselement des Ringoszillator zugeordnet ist. Durch mehrere Lastelemente, welche individuell entsprechend der Schaltdaten der Konfigurationseinheit mit Hilfe der Schalteinheit den Ausgängen der jeweils zugeordneten Verzögerungselemente zugeschaltet werden, kann eine sehr feinstufige und genaue Korrektur der Frequenz des Ringoszillators bzw. Anpassung an die vorgegebenen Frequenz erfolgen.

Bei einer Zuordnung von einem weiteren Lastelement zum Verzögerungselement, welche bereits das zumindest eine Lastelement zugeordnet ist, sind die Lastelemente idealerweise parallel angeordnet und parallel dem Ausgang des Verzögerungselements zuschaltbar. Dadurch ist es möglich, eine Feinabstimmung der aktuellen Frequenz durchzuführen und Fehler bzw. Störungen beim Zu- bzw. Wegschalten eines Lastelements gering zu halten. Weiterhin ist eine derartige Anordnung von Lastelementen sehr einfach in einem programmierbaren Logikbaustein realisierbar.

Eine bevorzugte Ausgestaltung des erfindungsgemäßen Systems sieht vor, dass das erfindungsgemäße System als Schaltungsteil eines so genannten Field Programmable Gate Arrays oder FPGAs realisiert ist - insbesondere das FPGAs so genannte partiell re-konfigurierbare Bereiche aufweisen, welche idealerweise für die Umsetzung der Schalteinheit und gegebenfalls für die Realisierung des zumindest einen Lastelements bzw. der zuschaltbaren Last verwendet werden können.

### Kurzbeschreibung der Zeichnung

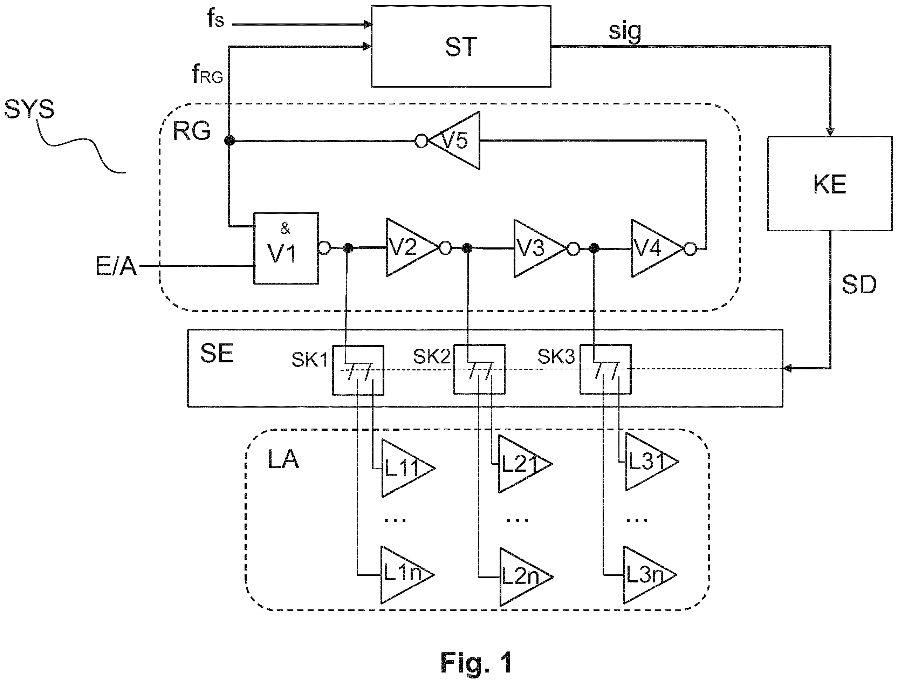

Die Erfindung wird nachfolgend in beispielhafter Weise anhand der beigefügten Figur 1 erläutert. Dabei zeigt die Figur 1 schematisch und beispielhaft ein System zur Durchführung des erfindungsgemäßen Verfahrens zur Frequenzkorrektur eines Ringoszillators sowie eine beispielhaften Ablauf des erfindungsgemäßen Verfahrens.

### Ausführung der Erfindung

Figur 1 zeigt beispielhaft und schematisch das System SYS zur Durchführung des erfindungsgemäßen Verfahrens zur Frequenzkorrektur für einen Ringoszillators RG. Das System SYS, welches als Schaltungsteil eines programmierbaren Logikbausteine, insbesondere eines so genannten Field Programmable Gate Arrays oder FPGAs, ausgeführt sein kann, weist einen Ringoszillator RG zum Erzeugen eines periodischen Signals auf. Der Ringoszillator besteht aus einer ungeraden Anzahl an in Serie angeordneten Verzögerungselementen V1, ..., V5, welche gegengekoppelt sind.

Der in Figur 1 beispielhaft dargestellte Ringoszillator RG weist z.B. fünf Verzögerungselemente V1, ..., V5 auf, wobei ein erstes Verzögerungselemente V1 beispielsweise als so genanntes NAND-Gatter ausgeführt ist, und zum Ein- bzw. Ausschalten des Ringoszillators einen Eingang für ein entsprechendes Einund Ausschaltsignal E/A aufweist. Die weiteren Verzögerungselemente V2, ..., V5 sind beispielsweise als Inverter oder als NICHT- bzw. NOT-Gatter ausgeführt, wobei der Ausgang des fünften Verzögerungselements V5 an einen weiteren Eingang des ersten Verzögerungselements V1 zurückgeführt ist.

Weiterhin umfasst das System SYS eine Steuereinheit, von welcher eine aktuelle Frequenz f_{RG} des vom Ringoszillator RG erzeugten, periodischen Signals mit einer vorgegebenen Frequenz fs verglichen wird. Die vorgegebenen Frequenz fs kann beispielsweise von einem Synchronisationssignal geliefert werden. Von der Steuereinheit wird bei einer festgestellten Abweichung zwischen aktueller Frequenz f_{RG} des Ringoszillators und der vorgegebenen Frequenz ein Steuersignal sig erstellt werden.

Das System SYS weist weiterhin eine zusätzliche Last LA für eine Frequenzkorrektur des Ringoszillators RG auf. Diese zusätzliche Last LA umfasst zumindest ein Lastelement L11, ..., L3n, welches aus einer Verbindung und einem daran angeschlossenen Logikelement besteht. Für eine Frequenzkorrektur des Ringoszillators RG ist das zumindest eine Lastelement L11, ..., L3n zumindest einem Verzögerungselement V1, ..., V5 des Ringoszillators zugeordnet.

In der in Figur 1 beispielhaft dargestellten Ausführungsvariante des erfindungsgemäßen System sind z.B. jeweils dem ersten, einem zweiten und einem dritten Verzögerungselement V1, V2, V3 Lastelemente L11, ..., L3n zugeordnet. So sind beispielsweise dem ersten Verzögerungselement V1 die Lastelemente L11, ..., L1n, dem zweiten Verzögerungselement die Lastelemente L21, ..., L2n und dem dritten Verzögerungselement die Lastelemente L31, ..., L3n zugeordnet. Einem vierten wie dem fünften Verzögerungselement V4, V5 des Ringoszillators sind beispielsweise keine Lastelemente zugeordnet. Ein Aufbau und eine Dimensionierung der zusätzlichen Last LA - wie z.B. Anzahl der Lastelemente L11, ..., L3n; die Zuordnung der Lastelemente L11, ..., L3n zu den Verzögerungselementen V1, ..., V5 des Ringoszillators RG; eine Anzahl der einem Verzögerungselement V1, ..., V5 zugeordneten Lastelemente L11, ..., L3n; eine Auswahl des für das jeweilige Lastelement L11, ..., L3n verwendete Logikelement, etc. - sind allerdings vom jeweiligen Anwendungsfall abhängig und müssen an die jeweiligen Anforderungen des jeweiligen Anwendungsfalls angepasst werden, um eine optimale Frequenzkorrektur zu erhalten.

Weiterhin umfasst das System SYS eine Schalteinheit SE, durch welche beispielsweise mittels Schaltelementen bzw. Schaltknoten SK1, SK2, SK3 das zumindest eine Lastelement L11, ..., L3n einem Ausgang des jeweils zugeordneten Verzögerungselements V1, ..., V5 zuschaltbar ist. D.h. bei der beispielhaft dargestellten Ausführungsvariante des Systems SYS sind beispielsweise die Logikelemente der Lastelemente L11, ..., L1n über die zugehörigen Verbindungen mit Hilfe eines ersten Schaltknotens SK1 der Schalteinheit SE mit dem Ausgang des ersten Verzögerungselements V1 verknüpfbar. Analog sind z.B. die Logikelemente der Lastelemente L21, ..., L2n bzw. L31, ..., L3n über die jeweils zugehörigen Verbindungen über die Schaltknoten SK2, SK3 der Schalteinheit SE dem Ausgang des jeweils zugeordneten zweiten bzw. dritten Verzögerungselement V2 bzw. V3 des Ringoszillators RG zuschaltbar. Dabei sind jene Lastelemente L11, ..., L1n bzw. L21, ..., L2n bzw. L31, ..., L3n, welche demselben Verzögerungselement V1, V2, V3 zugeordnet sind, z.B. parallel angeordnet und über die Schalteinheit SE parallel mit dem Ausgang des jeweiligen Verzögerungselements V1, V2, V3 verknüpfbar.

Für ein Zuschalten des zumindest einen Lastelements L11, ..., L3n am Ausgang des jeweils zugeordneten Verzögerungselement V1, ..., V5 ist die Schalteinheit SE bei einer Abweichung der aktuellen Frequenz f_{RG} des Ringoszillators RG von der vorgegebenen Frequenz fs entsprechend einstellbar. D.h., das Schaltelement SE bzw. die Schaltknoten SK1, SK2, SK3 werden derart eingestellt bzw. programmiert, dass der Ausgang des zumindest eine Verzögerungselements V1, ..., V5 durch eine Verknüpfung mit dem zumindest einen zugeordneten Lastelement L11, ..., L3n belastet und dadurch eine Eigenfrequenz entsprechend einer Größe des jeweiligen zugeschalteten Lastelements L11, ..., L3n geringfügig reduziert wird.

Für die entsprechende Einstellung bzw. Programmierung der Schalteinheit SE weist das System SYS eine Konfigurationseinheit KE auf. Die Konfigurationseinheit KE ist dazu eingerichtet, aus dem Steuersignal sig der Steuereinheit ST Schaltdaten SD (z.B. Bitmuster, etc.) zu generieren. Anhand der Schaltdaten SD ist die Schalteinheit SE derart einstellbar bzw. sind die Schaltknoten SK1, SK2, SK3 der Schalteinheit SE derart programmierbar, dass die für eine Frequenzkorrektur notwendigen Lastelemente L11, ..., L3n den Ausgängen der jeweils zugeordneten Verzögerungselemente V1, ..., V3 zugeschaltet werden. Für eine dynamische Umprogrammierung wird die Schalteinheit SE idealerweise in einem so genannten partiell-konfigurierbaren Bereich des programmierbaren Logikbausteins, insbesondere des FPGAs, angeordnet. Dadurch kann die Schalteinheit SE während eines Betriebs des restlichen programmierbaren Logikbausteins bzw. des FPGAs für die Frequenzkorrektur entsprechend eingestellt bzw. umprogrammiert werden.

Für eine dynamische Gestaltung der zusätzlichen Last LA kann zusätzlich auch diese bzw. das zumindest eine Lastelement L11, ..., L3n im so genannten partiell-konfigurierbaren Bereich des programmierbaren Logikbausteins angeordnet sein.

Für die Durchführung der Frequenzkorrektur des Ringoszillators mit dem System SYS werden zuerst den Verzögerungselementen V1, ..., V5 je nach den Anforderungen des jeweiligen Anwendungsfalls bzw. der jeweiligen Funktion des Logikbausteins die Lastelemente L11, ..., L3n der zusätzlichen Last LA zugeordnet. Von der Steuereinheit ST wird dann die aktuelle Frequenz f_{RG} des vom Ringoszillator RG erzeugten, periodischen Signals mit der vorgegebenen Frequenz fs verglichen.

Wird von der Steuereinheit ST eine Abweichung der aktuellen Frequenz f_{RG} des vom Ringoszillator RG erzeugten, periodischen Signals von der vorgegebenen Frequenz fs festgestellt, so wird die Schalteinheit SE derart eingestellt, dass für eine Frequenzkorrektur Lastelemente L11, ..., L3n den Ausgängen jener Verzögerungselemente V1, ..., V5 zugeschaltet werden, welchen die jeweiligen Lastelemente L11, ..., L3n zugeordnet sind. So kann beispielsweise dem ersten Verzögerungselement V1 ein Lastelemente L11, dem zweiten Verzögerungselement V2 mehrere Lastelemente L21, ..., L2n und dem dritten Verzögerungselement V3 kein Lastelement zugeschaltet werden - je nach Bedarf für die Frequenzkorrektur.

Für die entsprechende Einstellung der Schalteinheit SE wird bei einer festgestellten Abweichung zwischen der aktuellen Frequenz f_{RG} des Ringoszillators RG und der vorgegebenen Frequenz fs von der Steuereinheit ST ein Steuersignal sig erzeugt. Aus diesem Steuersignal sig werden dann von der Konfigurationseinheit KE entsprechende Schaltdaten SD erzeugt, mit deren Hilfe die Schalteinheit SE entsprechend eingestellt wird. Dabei werden beispielsweise die Schaltknoten SK1, SK2, SK3 der Schalteinheit SE auf Basis der Schaltdaten SD derart programmiert, dass die Ausgänge der Verzögerungselemente V1, V2, V3 mit den für die Frequenzkorrektur notwendigen Lastelementen L11, ..., L3n (z.B. Anzahl an Lastelementen L11, ..., L3n je Ausgang) belastet werden. Dazu werden durch entsprechende Einstellung bzw. Programmierung des jeweiligen Schaltknotens SK1, SK2, SK3 zwischen dem Ausgang des jeweiligen Verzögerungselements V1, V2, V3 und den Verbindungen der jeweils zugeordneten Lastelemente L11, ..., L3n auf Basis der Schaltdaten Verknüpfungen hergestellt.

Durch das erfindungsgemäße Verfahren und das zugehörige System SYS kann die Frequenz f_{RG} des vom Ringoszillator RG erzeugten, periodischen Signals zu einem vorgegebenen Zeitpunkt - z.B. beim Start des Ringoszillators RG; beim Start einer Anwendung, für welche der Ringoszillator RG genutzt wird, etc. - einmalig auf die vorgegebenen Frequenz fs eingestellt bzw. kalibriert werden.

Alternativ bieten das erfindungsgemäße Verfahren und das zugehörige System auch die Möglichkeit, die Frequenz f_{RG} des vom Ringoszillator RG erzeugten, periodischen Signals der vorgegebenen Frequenz fs z.B. anhand eines laufenden Vergleichs dieser Frequenzen f_{RG}, fs durch die Steuereinheit ST und einer entsprechenden, auf einem Vergleichsergebnis basierenden Umprogrammierung der Schalteinheit SE laufend nachzuregeln.

## Patentansprüche

1. Verfahren zur Frequenzkorrektur für einen Ringoszillator (RG), von welchem ein periodisches Signal in einem programmierbaren Logikbaustein erzeugt wird und welcher aus einer ungeraden Anzahl an gegengekoppelten, in Serie angeordneten Verzögerungselementen (V1, ..., V5) besteht, wobei zumindest einem Verzögerungselement (V1, ..., V5) des Ringoszillators (RG) zumindest ein Lastelement (L11, ..., L3n) einer zusätzlichen Last (LA) zugeordnet wird, wobei eine aktuelle Frequenz (f_{RG}) des vom Ringoszillator (RG) erzeugten, periodischen Signals von einer Steuereinheit (ST) mit einer vorgegebenen Frequenz (fs) verglichen wird, **dadurch gekennzeichnet, dass** bei Abweichung zwischen der aktuellen Frequenz (f_{RG}) des vom Ringoszillator (RG) erzeugten, periodischen Signals und der vorgegebenen Frequenz (fs) von der Steuereinheit ein Steuersignal (sig) erzeugt wird, dass aus dem Steuersignal (sig) der Steuereinheit (ST) von einer Konfigurationseinheit (KE) Schaltdaten (SD) zum Einstellen einer Schalteinheit (SE) generiert werden, dass die Schalteinheit (SE) mittels der Schaltdaten (SD) derart programmiert wird, dass das zumindest eine Lastelement (L11, ..., L3n) einem Ausgang jenes Verzögerungselements (V1, ..., V5) zugeschaltet wird, welchem das zumindest eine Lastelement (L11, ..., L3n) zugeordnet ist, und dass die Schalteinheit (SE) in einem so genannten partiell re-konfigurierbaren Bereich des programmierbaren Logikbausteins angeordnet wird.

2. Verfahren nach Anspruch 1, ***dadurch gekennzeichnet, dass*** das zumindest eine Lastelement (L11, ..., L3n) aus einer Verbindung mit angeschlossenem Logikelement aufgebaut wird, und dass das zumindest eine Lastelement (L11, ..., L3n) durch die Verbindung bei entsprechender Einstellung der Schalteinheit (SE) dem Ausgang jenes Verzögerungselements (V1, ..., V5) zugeschaltet wird, welchem das zumindest einen Lastelement (L11, ..., L3n) der zusätzlichen Last (LA) zugeordnet ist.

3. Verfahren nach einem der Ansprüche 1 bis 2, ***dadurch gekennzeichnet, dass*** zusätzlich zur Schalteinheit (SE) auch das zumindest eine Lastelement (L11, ..., L3n) bzw. die zusätzliche Last (LA) im so genannten partiell re-konfigurierbaren Bereich des programmierbaren Logikbausteins angeordnet wird.

4. Verfahren nach einem der Ansprüche 1 bis 3, ***dadurch gekennzeichnet, dass*** die aktuelle Frequenz (f_{RG}) des vom Ringoszillator (RG) erzeugten, periodischen Signals zu einem vorgegebenen Zeitpunkt entsprechend der vorgegebenen Frequenz (fs) kalibriert wird.

5. Verfahren nach einem der Ansprüche 1 bis 3, ***dadurch gekennzeichnet, dass*** die aktuelle Frequenz (f_{RG}) des vom Ringoszillator (RG) erzeugten, periodischen Signals laufend entsprechend der vorgegebenen Frequenz (fs) nachgeregelt wird.

6. System zur Durchführung eines Verfahrens zur Frequenzkorrektur für einen Ringoszillator (RG) nach einem der Ansprüche 1 bis 5, welches einen Ringoszillator (RG) zum Erzeugen von periodischen Signalen in einem programmierbaren Logikbaustein umfasst, wobei der Ringoszillator (RG) aus einer ungeraden Anzahl an gegengekoppelten, in Serie angeordneten Verzögerungselementen (V1, ..., V5) besteht, ***dadurch gekennzeichnet, dass*** das System (SYS) aufweist:
- eine Steuereinheit (SR) zum Vergleichen einer aktuellen Frequenz (f_{RG}) des erzeugten, periodischen Signals des Ringoszillators (RG) mit einer vorgegebenen Frequenz (fs) und zum Erzeugen eines Steuersignals (sig) bei einer Abweichung der aktuellen Frequenz (f_{RG}) des erzeugten, periodischen Signals des Ringoszillators (RG) von der vorgegebenen Frequenz (fs),
- eine zusätzliche Last (LA) für eine Frequenzkorrektur des Ringoszillators (RG) mit zumindest einem Lastelement (L11, ..., L3n), wobei zumindest einem Verzögerungselement (V1, ..., V5) des Ringoszillators (RG) das zumindest eine Lastelement (L11, ..., L3n) zugeordnet ist,
- eine Schalteinheit (SE), welche bei einer Abweichung der aktuellen Frequenz (f_{RG}) des erzeugten, periodischen Signals des Ringoszillators (RG) von der vorgegebenen Frequenz (fs) derart mittels Schaltdaten (SD) programmierbar ist, dass das zumindest eine Lastelement (L11, ..., L3n) der zusätzlichen Last (LA) einem Ausgang jenes Verzögerungselements (V1, ..., V5) zugeschaltet wird, welchem das zumindest eine Lastelement (L11, ..., L1n) zugeordnet ist, und wobei zumindest die Schalteinheit (SE) in einem so genannten partiell re-konfigurierbaren Bereich des Logikbausteins angeordnet ist, und
eine Konfigurationseinheit (KE), welche auf Basis eines Steuersignals (sig) der Steuereinheit (ST) die Schaltdaten (SD) zum Einstellen der Schalteinheit (SE) generiert.

7. System nach Anspruch 6, ***dadurch gekennzeichnet, dass*** das zumindest eine Lastelement (L11, ..., L3n) aus einer Verbindung mit daran angeschlossenem Logikelement besteht, wobei das zumindest eine Lastelement (L11, ..., L3n) bei entsprechender Einstellung der Schalteinheit (SE) über die Verbindung dem Ausgang des zugeordneten Verzögerungselements (V1, ..., V5) zuschaltbar ist.

8. System nach einem der Ansprüche 6 bis 7, ***dadurch gekennzeichnet, dass*** zusätzlich zum zumindest eine Lastelement (L11, ..., L3n) zumindest ein weiteres Lastelement (L11, ..., L3n) vorgesehen ist, welches demselben Verzögerungselement (V1, ..., V5) wie das zumindest eine Lastelement (L11, ..., L3n) oder einem weiteren Verzögerungselement (V1, ..., V5) des Ringoszillator (RG) zugeordnet ist.

9. System nach Anspruch 8, ***dadurch gekennzeichnet, dass*** das zumindest eine Lastelement (L11, ..., L3n) und das weitere Lastelement (L11 ,...,L3n)) bei Zuordnung zum selben Verzögerungselement (V1, ..., V5) parallel angeordnet und dem Ausgang des Verzögerungselements (V1, ..., V5) zuschaltbar sind.

10. System nach einem der vorangegangen Ansprüche, ***dadurch gekennzeichnet, dass*** das System (SYS) als Schaltungsteil eines so genannten Field Programmable Gate Arrays oder FPGAs realisiert ist.

## Claims

1. Method for frequency correction for a ring oscillator (RG), by which a periodic signal in a programmable logic chip is generated and which consists of an odd number of degenerative delay elements (V1, ..., V5) arranged in series, wherein at least one delay element (V1, ..., V5) of the ring oscillator (RG) is assigned at least one load element (L11, ..., L3n) of an additional load (LA), wherein a current frequency (f_{RG}) of the periodic signal generated by the ring oscillator (RG) is compared with a predefined frequency (fs) by a control unit (ST), **characterised in that**
in the event of a deviation between the current frequency (f_{RG}) of the periodic signal generated by the ring oscillator (RG) and the predefined frequency (fs), a control signal (sig) is generated by the control unit, that switching data (SD) for setting a switching unit (SE) is generated from the control signal (sig) of the control unit (ST) by a configuration unit (KE), that the switching unit (SE) is programmed by means of the switching data (SD) in such a manner that the at least one load element (L11, ..., L3n) is joined to an output of the delay element (V1, ..., V5) to which the at least one load element (L11, ..., L3n) is assigned, and that the switching unit (SE) is arranged in what is known as a partially reconfigurable region of the programmable logic chip.

2. Method according to claim 1, ***characterised in that*** the at least one load element (L11, ..., L3n) is established from a connection to the connected logic element, and that the at least one load element (L11, ..., L3n) is joined by the connection, with corresponding setting of the switching unit (SE), to the output of the delay element (V1, ..., V5) to which the at least one load element (L11, ..., L3n) of the additional load (LA) is assigned.

3. Method according to one of claims 1 to 2, ***characterised in that,*** in addition to the switching unit (SE), the at least one load element (L11, ..., L3n) or the additional load (LA) is also arranged in what is known as the partially reconfigurable region of the programmable logic chip.

4. Method according to one of claims 1 to 3, ***characterised in that*** the current frequency (f_{RG}) of the periodic signal generated by the ring oscillator (RG) is calibrated at a predefined point in time according to the predefined frequency (fs).

5. Method according to one of claims 1 to 3, ***characterised in that*** the current frequency (fRG) of the periodic signal generated by the ring oscillator (RG) is readjusted on an ongoing basis according to the predefined frequency (fs).

6. System for performing a method for frequency correction for a ring oscillator (RG) according to one of claims 1 to 5, which comprises a ring oscillator (RG) for generating periodic signals in a programmable logic chip, wherein the ring oscillator (RG) consists of an odd number of degenerative delay elements (V1, ..., V5) arranged in series, ***characterised in that*** the system (SYS) has:
- a control unit (SR) for comparing a current frequency (f_{RG}) of the generated periodic signal of the ring oscillator (RG) with a predefined frequency (fs) and for generating a control signal (sig) in the event of a deviation between the current frequency (f_{RG}) of the generated periodic signal of the ring oscillator (RG) and the predefined frequency (fs),
- an additional load (LA) for a frequency correction of the ring oscillator (RG) with at least one load element (L11, ..., L3n), wherein at least one delay element (V1, ..., V5) of the ring oscillator (RG) is assigned the at least one load element (L11, ..., L3n),
- a switching unit (SE) which, in the event of a deviation between the current frequency (f_{RG}) of the generated periodic signal of the ring oscillator (RG) and the predefined frequency (fs), can be programmed by means of switching data (SD) in such a manner that the at least one load element (L11, ..., L3n) of the additional load (LA) is joined to an output of the delay element (V1, ..., V5) to which the at least one load element (L11, ..., L1n) is assigned, and wherein at least the switching element (SE) is arranged in what is known as a partially reconfigurable region of the logic chip, and
a configuration unit (KE), which generates the switching data (SD) for setting the switching unit (SE) on the basis of a control signal (sig) of the control unit (ST).

7. System according to claim 6, ***characterised in that*** the at least one load element (L11, ..., L3n) consists of a connection to the logic element connected thereto, wherein the at least one load element (L11, ..., L3n) can be joined via the connection, with corresponding setting of the switching unit (SE), to the output of the assigned delay element (V1, ..., V5).

8. System according to one of claims 6 to 7, ***characterised in that,*** in addition to the at least one load element (L11, ..., L3n), at least one further load element (L11, ..., L3n) is provided, which is assigned to the same delay element (V1, ..., V5) as the at least one load element (L11, ..., L3n) or to a further delay element (V1, ..., V5) of the ring oscillator (RG) .

9. System according to claim 8, ***characterised in that*** the at least one load element (L11, ..., L3n) and the further load element (L11, ..., L3n), when assigned to the same delay element (V1, ..., V5), are arranged in parallel and can be joined to the output of the delay element (V1, ..., V5).

10. System according to one of the preceding claims, ***characterised in that*** the system (SYS) is implemented as a circuit part of what is known as a Field Programmable Gate Array or FPGA.

## Revendications

1. Procédé de correction de fréquence pour un oscillateur annulaire (RG) qui génère un signal périodique dans un composant logique programmable et qui est constitué d'un nombre impair d'éléments de temporisation (V1,..., V5) contre-couplés disposés en série,
dans lequel, à au moins un élément de temporisation (V1,..., V5) de l'oscillateur annulaire (RG), correspond au moins un élément de charge (L11,..., L3n) d'une charge supplémentaire (LA),
dans lequel une fréquence (f_{RG}) actuelle du signal périodique généré par l'oscillateur annulaire (RG) est comparée, par une unité de commande (ST), avec une fréquence prédéterminée (fs),
**caractérisé en ce que**, dans le cas d'un écart entre la fréquence actuelle (f_{RG}) du signal périodique généré par l'oscillateur annulaire (RG) et la fréquence prédéterminée (fs), un signal de commande (sig) est généré par l'unité de commande, **en ce que**, à partir du signal de commande (sig) de l'unité de commande (ST), des données de commutation (SD) pour le réglage d'une unité de commutation (SE) sont générées par une unité de configuration (KE), **en ce que** l'unité de commutation (SE) est programmée au moyen des données de commutation (SD) de sorte que l'au moins un élément de charge (L11,..., L3n) est branché à une sortie de l'élément de temporisation (V1,..., V5) auquel correspond l'au moins un élément de charge (L11,..., L3n) et **en ce que** l'unité de commutation (SE) est disposée dans une zone, appelée zone partiellement reconfigurable, du composant logique programmable.

2. Procédé selon la revendication 1, **caractérisé en ce que** l'au moins un élément de charge (L11,..., L3n) est constitué d'une liaison avec un élément logique connecté, et **en ce que** l'au moins un élément de charge (L11,..., L3n) est ajouté, par la liaison lors d'un réglage correspondant de l'unité de commutation (SE), à la sortie de l'élément de temporisation (V1,..., V5) auquel correspond l'au moins un élément de charge (L11,..., L3n) de la charge supplémentaire (LA).

3. Procédé selon l'une des revendications 1 à 2, **caractérisé en ce que**, en plus de l'unité de commutation (SE), l'au moins un élément de charge (L11,..., L3n) ou la charge supplémentaire (LA) est également disposée dans la zone, appelée zone partiellement reconfigurable, du composant logique programmable.

4. Procédé selon l'une des revendications 1 à 3, **caractérisé en ce que** la fréquence actuelle (f_{RG}) du signal périodique généré par l'oscillateur annulaire (RG) est calibrée à un moment prédéterminé correspondant à la fréquence (fs) prédéterminée.

5. Procédé selon l'une des revendications 1 à 3, **caractérisé en ce que** la fréquence actuelle (f_{RG}) du signal périodique généré par l'oscillateur annulaire (RG) est réajustée en continu en fonction de la fréquence prédéterminée (fs).

6. Système pour l'exécution d'un procédé de correction de fréquence pour un oscillateur annulaire (RG) selon l'une des revendications 1 à 5, qui comprend un oscillateur annulaire (RG) pour la génération de signaux périodiques dans un composant logique programmable, dans lequel l'oscillateur annulaire (RG) est constitué d'un nombre impair d'éléments de temporisation (V1,..., V5) contre-couplés disposés en série, **caractérisé en ce que** le système (SYS) comprend :
- une unité de commande (SR) pour la comparaison d'une fréquence actuelle (f_{RG}) du signal périodique généré par l'oscillateur annulaire (RG) avec une fréquence prédéterminée (fs) et pour la génération d'un signal de commande (sig) lors d'un écart entre la fréquence actuelle (f_{RG}) du signal périodique généré par l'oscillateur annulaire (RG) et la fréquence prédéterminée (fs),
- une charge supplémentaire (LA) pour une correction de fréquence de l'oscillateur annulaire (RG) avec au moins un élément de charge (L11,..., L3n), dans lequel, à au moins un élément de temporisation (V1,..., V5) de l'oscillateur annulaire (RG), correspond l'au moins un élément de charge (L11,..., L3n),
- une unité de commutation (SE) qui, lors d'un écart entre la fréquence actuelle (f_{RG}) du signal périodique généré par l'oscillateur annulaire (RG) et la fréquence prédéterminée (fs), peut être programmée au moyen de données de commutation (SD), de sorte que l'au moins un élément de charge (L11,..., L3n) de la charge supplémentaire (LA) est ajouté à une sortie de l'élément de temporisation (V1,..., V5) auquel correspond l'au moins un élément de charge (L11,..., L1n), et dans lequel au moins l'unité de commutation (SE) est disposée dans une zone, appelée zone partiellement reconfigurable, du composant logique et une unité de configuration (KE) qui génère, sur la base d'un signal de commande (sig) de l'unité de commande (ST), les données de commutation (SD) pour le réglage de l'unité de commutation (SE) .

7. Système selon la revendication 6, **caractérisé en ce que** l'au moins un élément de charge (L11,..., L3n) est constitué d'une liaison avec un élément logique connecté, dans lequel l'au moins un élément de charge (L11,..., L3n) peut être ajouté, lors d'un réglage correspondant de l'unité de commutation (SE), grâce à la liaison avec la sortie de l'élément de temporisation (V1,..., V5) correspondant.

8. Système selon l'une des revendications 6 à 7, **caractérisé en ce que**, en outre, sur l'au moins un élément de charge (L11,..., L3n), est prévu au moins un autre élément de charge (L11, ..., L3n) qui correspond au même élément de temporisation (V1,..., V5) que l'au moins un élément de charge (L11,..., L3n) ou à un autre élément de temporisation (V1,..., V5) de l'oscillateur annulaire (RG) .

9. Système selon la revendication 8, **caractérisé en ce que** l'au moins un élément de charge (L11,..., L3n) et l'autre élément de charge (L11,..., L3n) sont disposés en parallèle lors de la mise en correspondance avec le même élément de temporisation (V1,..., V5) et peuvent être ajoutés à la sortie de l'élément de temporisation (V1, ..., V5).

10. Système selon l'une des revendications précédentes, **caractérisé en ce que** le système (SYS) est réalisé sous la forme d'une partie de circuit de ce qu'on appelle Field Programmable Gate Arrays ou FPGA.
